# EUROPEAN PATENT APPLICATION

(11) **EP 4 727 016 A1**
(43) Date of publication of application: **15.04.2026**
(21) Application number: 25207015.6
(22) Date of filing: 06.10.2025
(51) Int. Cl.: H03M 1/06

(54) **IMPROVING DYNAMIC RANGE OF ANALOG-TO-DIGITAL CONVERTERS FOR ANTENNA ARRAYS**

(30) Priority: 08.10.2024 US 202418909525
(71) Applicant: Daedalean AG, 8074 Zurich (CH)
(72) Inventor: Lawson,, James Edward, 8003 Zurich (CH)
(74) Representative: Potter Clarkson

(57) **Abstract**

Systems and methods to improve dynamic range of analog-to-digital converters (ADCs) for use with antennas are disclosed. Exemplary implementations may include an array of receiver elements that include receiver antennas, a noise-specific antenna, ADCs, and/or other components. Implementations may receive radio signals and transmit a noise signal such that the noise signal is part of the received radio signals. Implementations may convert an analog input signal into a digital output signal, wherein the analog input signal is derived from the received radio signals, and wherein the digital output signal includes one or more spurious tones. The individual ADCs have a Spurious-Free Dynamic Range (SFDR) that is improved by virtue of spreading power of one or more spurious tones over a particular bandwidth.

## Description

### FIELD OF THE DISCLOSURE

The present disclosure relates to systems and methods to improve dynamic range of analog-to-digital converters (ADCs) for use with antennas.

### BACKGROUND

Analog-to-digital converters (ADCs) are known, in particular in (radio frequency) radar systems and communication systems. Aircraft are known.

### SUMMARY

One aspect of the present disclosure relates to a (radio receiver) system configured for improving dynamic range of analog-to-digital converters (ADCs) for use with antennas. As used herein, the phrase "configured to" is intended to be interpreted broadly, as "being capable of or suitable for performing" some function or feature, without requiring any adaptations to provide said function or feature. The radio receiver system includes an array of receiver elements that include receiver antennas, a noise-specific antenna, ADCs, and/or other components. The system may receive radio signals and transmit a noise signal such that the noise signal is part of the received radio signals. The system may convert an analog input signal into a digital output signal, wherein the analog input signal is derived from the received radio signals, and wherein the digital output signal includes one or more spurious tones. The individual ADCs have a Spurious-Free Dynamic Range (SFDR) that is improved by virtue of spreading power of one or more spurious tones over a particular bandwidth.

Another aspect of the present disclosure related to a method of improving dynamic range of analog-to-digital converters (ADCs) for use with antennas. The method may include receiving radio signals and transmitting a noise signal such that the noise signal is part of the received radio signals. The method may include converting an analog input signal into a digital output signal (using one or more ADCs), wherein the analog input signal is derived from the received radio signals, and wherein the digital output signal includes one or more spurious tones. The individual ADCs have a Spurious-Free Dynamic Range (SFDR) that is improved by virtue of spreading power of one or more spurious tones over a particular bandwidth.

As used herein, the term "aircraft" is used for both singular and plural. As used herein, any association (or relation, or reflection, or indication, or correspondency, or correlation) involving antennas, receiver elements, radio signals, noise sources, noise signals, ADCs, input signals, output signals, spurious tones, dynamic ranges, frequencies, aircraft, servers, processors, computing platforms, users, instructions, identifiers, notifications, determinations, interfaces, and/or another entity or object that interacts with any part of the system and/or plays a part in the operation of the system, may be a one-to-one association, a one-to-many association, a many-to-one association, and/or a many-to-many association or "N"-to-"M" association (note that "N" and "M" may be different numbers greater than 1).

As used herein, the term "obtain" (and derivatives thereof) may include active and/or passive retrieval, determination, derivation, transfer, upload, download, submission, and/or exchange of information, and/or any combination thereof. As used herein, the term "effectuate" (and derivatives thereof) may include active and/or passive causation of any effect, both local and remote. As used herein, the term "determine" (and derivatives thereof) may include measure, calculate, compute, estimate, approximate, generate, and/or otherwise derive, and/or any combination thereof.

These and other features, and characteristics of the present technology, as well as the methods of operation and functions of the related elements of structure and the combination of parts and economies of manufacture, will become more apparent upon consideration of the following description and the appended claims with reference to the accompanying drawings, all of which form a part of this specification, wherein like reference numerals designate corresponding parts in the various figures. It is to be expressly understood, however, that the drawings are for the purpose of illustration and description only and are not intended as a definition of the limits of the invention. As used in the specification and in the claims, the singular form of "a", "an", and "the" include plural referents unless the context clearly dictates otherwise.

### BRIEF DESCRIPTION OF THE DRAWINGS

FIG. 1 illustrates a radio receiver system configured for improving dynamic range of analog-to-digital converters (ADCs) for use with antennas, in accordance with one or more implementations.
FIG. 2 illustrates a method of improving dynamic range of analog-to-digital converters (ADCs) for use with antennas, in accordance with one or more implementations.
FIG. 3 illustrates a method of improving dynamic range of analog-to-digital converters (ADCs) for use with antennas, in accordance with one or more implementations.
FIG. 4A illustrates an exemplary function for an analog-to-digital converter (ADC).
FIG. 4B depicts a diagram illustrating different types of dynamic range.
FIG. 5A illustrates an exemplary receiver element as may be used in a radio receiver system configured for improving dynamic range of analog-to-digital converters (ADCs) for use with antennas, in accordance with one or more implementations.
FIG. 5B illustrates an exemplary low-power noise source as may be used in a radio receiver system configured for improving dynamic range of analog-to-digital converters (ADCs) for use with antennas, in accordance with one or more implementations.
FIG. 6A depicts a diagram illustrating SFDR of an ADC without an added noise signal.
FIG. 6B depicts a diagram illustrating SFDR of an ADC using an added noise signal.

### DETAILED DESCRIPTION

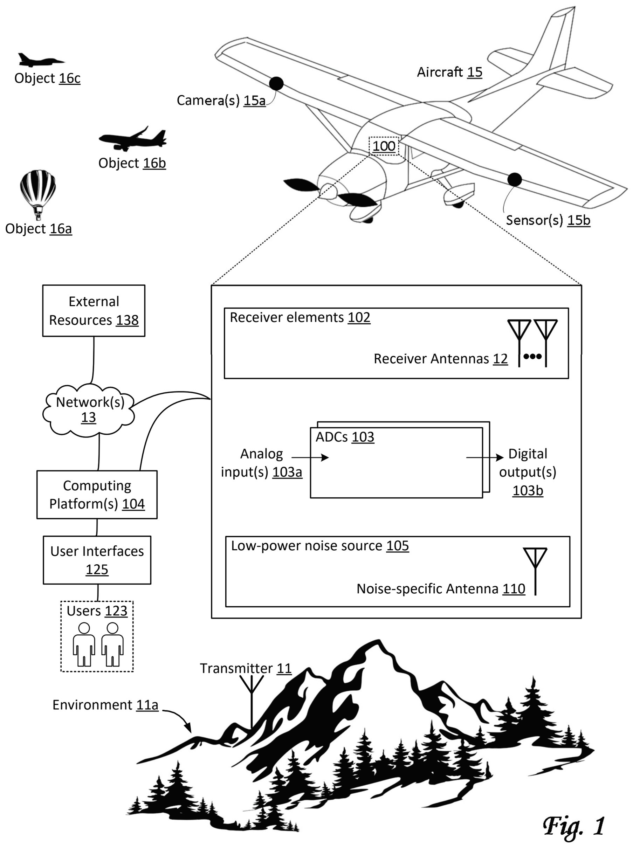

FIG. 1 illustrates a radio receiver system 100 configured for improving dynamic range of analog-to-digital converters (ADCs) for use with antennas, in accordance with one or more implementations. Radio receiver system 100 may include one or more receiver elements 102, multiple analog-to-digital converters (ADCs) 103, a low-power noise source 105, one or more computing platform(s) 104, one or more user interface(s) 125, and/or other components. Individual receivers are included in individual aircraft. In some implementations, radio receiver system 100 may be embedded in a particular aircraft 15. In some implementations, radio receiver system 100 may include particular aircraft 15. Receiver elements 102 may be arranged in a set or array of receiver elements. Analog-to-digital converters (ADCs) 103 may be arranged in a set or array of ADCs.

Radio receiver system 100 may be part of a (radio frequency) radar system that includes one or more transmitters *(e.g.,* a stationary transmitter 11 in an environment 11a, *e.g.,* an outdoor environment), receivers *(e.g.,* radio receiver system 100 as carried by aircraft 15), and/or airborne targets *(e.g.,* objects such as an object/aircraft 16a, an object/aircraft 16b, an object/aircraft 16c). The one or more transmitters may transmit information, *e.g.,* as radio signals. Such radio signals may be received (directly) by receivers such as radio receiver system 100. Additionally, such signals may be reflected, *e.g.,* by airborne targets, and these reflected radio signals may be received (indirectly) by receivers such as radio receiver system 100. Directly received radio signals may be much stronger than reflected radio signals, particularly in a case where aircraft 15 is physically close to stationary transmitter 11 and far from, say, object 16a. Received radio signals may convey information, such as, by way of non-limiting example, information about the location of airborne targets.

Radio frequencies may range from 100s of MHz to 100s of GHz (or more), though common frequencies are typically about 2, 3, 5, or 10 GHz. Received radio signals are typically down-converted to lower frequencies in the 1-100 MHz range, e.g., in an intermediate frequency band of about 12-24 MHz, or about 30-50 MHz, or another frequency band. Subsequently, these down-converted analog signals are converted to digital signals through analog-to-digital converters (ADCs) for further processing and analysis, *e.g.,* to extract and/or interpret conveyed information, including but not limited to detection of airborne objects including other aircraft. In some cases, detection of an airborne object may include determining its azimuth angle, elevation angle, and/or distance from, *e.g.,* aircraft 15. Detection of other airborne objects, in particular aircraft, while flying is needed to avoid collisions, among other issues. Interpreting and acting on the content of such digital signals may be outside of the scope of this disclosure. Certain performance aspects of receivers such as radio receiver system 100 are limited and/or otherwise controlled by operating characteristics of the analog-to-digital converters (ADCs), particularly by the dynamic range of the analog-to-digital converters (ADCs), especially when both strong and weak radio signals are received by radio receiver system 100 at the same time. In some implementations, radio receiver system 100 may be used in and/or part of a communication system.

By virtue of the features described in this disclosure, the dynamic range of the analog-to-digital converters (ADCs) in radio receiver system 100 may be improved, thus improving the performance of radio receiver system 100 itself. In particular, the Spurious-Free Dynamic Range (SFDR) of the ADCs may be improved by spreading the power of one or more types of noise (in particular of certain spurious tones), e.g., over a particular bandwidth.

Users 123 (also referred to as users) may include one or more of a first user, a second user, a third user, and/or other users. As used in descriptions herein, any use of the term "user" may refer to user(s) 123, unless indicated otherwise.

Referring to FIG. 1, radio receiver system 100 may be specific to an aircraft, such as aircraft 15. Radio receiver system 100 may include an array of receiver elements 102. In some implementations, individual receiver elements may be configured to receive radio signals in individual channels *(e.g.,* within a particular (sub)frequency band). Typically, an individual receiver element 102 includes an individual receiver antenna 12, such that an array of receiver elements 102 includes a corresponding array of receiver antennas 12. In some implementations, radio receiver system 100 may include 4, 8, 16, 32, or more receiver elements 102, and at least the same number of receiver antennas 12.

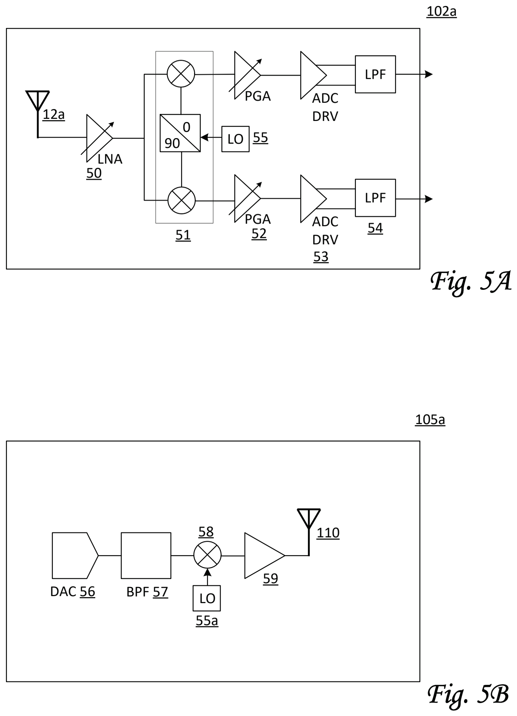

Receiver antenna 12 may be configured to receive radio signals, *i.e.,* (analog) signals in a radio frequency range. These received radio signals may include one or more noise signals, including but not limited to a noise signal generated and/or transmitted by low-power noise source 105. By way of non-limiting example, FIG. 5A illustrates an exemplary receiver element 102a as may be used by radio receiver system 100. As depicted in FIG. 5A, receiver element 102a may include one or more of a receiver antenna 12a, a low noise amplifier (LNA) 50 (which may be configured to have switchable gain to reduce the gain for strong signals), an IQ mixer 51 that has a local oscillator (LO) 55 as input, and that has two outputs (in-phase (I) and quadrature (Q) down-converted (and/or decomposed) signals that are derived and/or generated by mixing the LNA signal with the signal from local oscillator 55), an amplifier such as a programmable gain amplifier (PGA) 52 for each of the two IQ outputs, an ADC driver 53 for each of the two IQ outputs to provide a higher drive current, a low-pass filter (LPF) 54 for each of the two IQ outputs to remove harmonic content, and/or other components. The outputs for each of the LPFs 54 may act as analog inputs 103a (as depicted in FIG. 1) into ADCs 103 (as depicted in FIG. 1).

Referring to FIG. 1, low-power noise source 105 may be configured to generate and/or transmit one or more noise signals. The noise signal is sometimes referred to as a dither signal. Low-power noise source 105 includes noise-specific antenna 110 and/or other components. Noise-specific antenna 110 may be configured to transmit a noise signal. Noise-specific antenna 110 may be positioned at or near receiver elements 102 such that the noise signal is received by receiver antennas 12 of receiver elements 102. In other words, the radio signals received by receiver antennas 12 may include the noise signal transmitted by noise-specific antenna 110. In some implementations, low-power noise source 105 and/or noise-specific antenna 110 may be carried by aircraft 15. In some implementations, low-power noise source 105 may be implemented using a noise diode or similar analog source, instead of the example depicted in FIG. 5B.

By way of non-limiting example, FIG. 5B illustrates an exemplary low-power noise source 105a as may be used by radio receiver system 100. As depicted in FIG. 5B, low-power noise source 105a may include one or more of a digital-to-analog converter (DAC) 56, a bandpass filter (BPF) 57, a local oscillator (LO) 55a, a mixer 58, an amplifier 59, noise-specific antenna 110, and/or other elements. In some implementations, random numbers may be generated by radio receiver system 100 (not depicted in FIG. 5B) that serve as input to DAC 56, which has a digital input and an analog output. The analog output may go through BPF 57 into mixer 58 for up-conversion into a radio frequency band, and then through amplifier 59 to noise-specific antenna 110 for transmission. Other input sources for random information as input to DAC 56 are considered within the scope of this disclosure.

Referring to FIG. 1, in some implementations, the noise signal transmitted by noise-specific antenna 110 may be generated to cover the entire operating band of radio receiver system 100. The noise signal may include frequencies in the operating band of radio receiver system 100. In some cases, the noise signal may be band-limited, e.g., to a frequency band that is otherwise unused by radio receiver system 100.

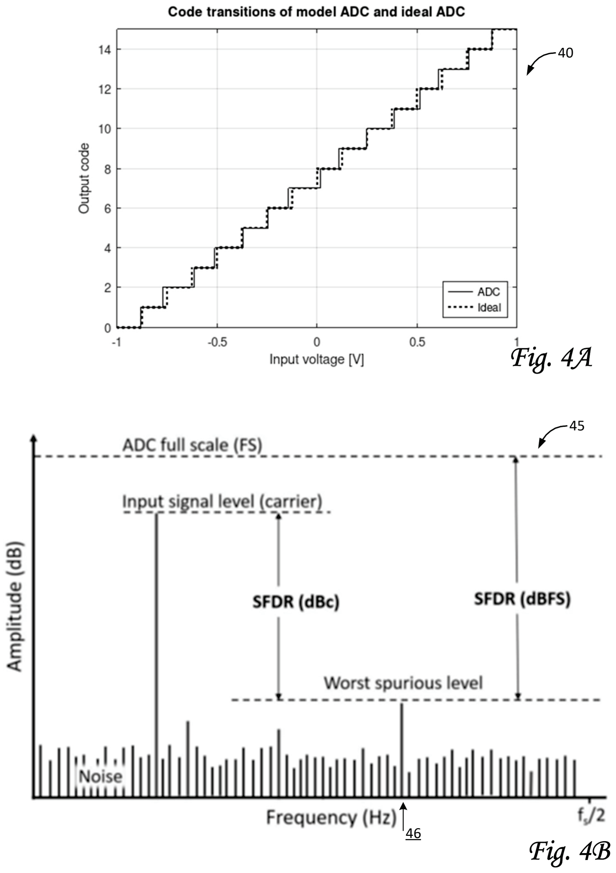

Analog-to-digital converter (ADC) 103 may be configured to convert analog input signal 103a into digital output signal 103b. ADC 103 may be an integrated circuit that quantizes an analog input voltage to produce a digital output of "N" bits wide (this is also referred to as the "code width"). For example, a 4-bit ADC has 16 different output codes, from "0000" to "1111". In the real world, any ADC has some quantization error, as well as other types of errors and noise. ADC 103 performs this conversion periodically, by sampling analog input signal 103a at a sampling rate, also referred to as sampling frequency fₛ. In some cases, input signals up to a frequency of half the sampling frequency may be converted without loss. In simple conventional cases, the frequency band up to fₛ/2 is also referred to as the Nyquist bandwidth. In complex sampled (IQ) systems, the Nyquist bandwidth is up to fₛ. In some cases, band-limited input signals (limited to the Nyquist bandwidth) that are under-sampled can be digitized without aliasing. In some cases, digital output signal 103b may be within a particular bandwidth. By way of non-limiting example, FIG. 4A illustrates an exemplary function 40 for an ideal and a real-world 4-bit analog-to-digital converter (using a dotted and a solid line, respectively), with an analog input signal (from -1V to 1V) on the horizontal axis and a digital output signal (from 0 to 15) on the vertical axis.

Referring to FIG. 1, the performance of ADC 103 is characterized by one or more of its sampling rate, signal-to-noise ratio (SNR), linearity, accuracy, and/or other characteristics. Additionally, noise or dither on analog input signal 103a (which may include the noise signal transmitted by noise-specific antenna 110 and received by receiver antennas 12) affects the performance of ADC 103. For each individual ADC 103, its analog input signal 103a is provided by (one of the low-pass filters of) an individual receiver element 102. See FIG. 5A for additional details. Accordingly, an implementation of radio receiver system 100 with an array of 16 receiver elements 102 (and 16 corresponding receiver antennas 12) will have 32 ADCs 103. In some cases, an implementation of radio receiver system 100 with an array of 32 receiver elements 102 (and 32 corresponding receiver antennas 12) will have 64 ADCs 103.

Digital output signals 103b of ADCs 103 include spurious tones, due to one or both of internal imperfections as well as noise or dither on analog input signals 103a. By way of non-limiting example, such imperfections may include one or more of differential nonlinearities, integral nonlinearities, static nonlinearities, quantization errors, and/or other imperfections or (harmonic) distortions. In some cases, spurious tones are due to quantization errors of ADCs 103. Spurious tones (as well as other imperfections or distortions) limit the dynamic range of ADCs 103. By way of non-limiting example, FIG. 4B depicts a diagram 45 illustrating different types of dynamic range for an analog-to-digital converter. Spurious-Free Dynamic Range (SFDR) is defined as a strength ratio of a minimum detectable signal level included in the analog input signal and a maximum level of any of the spurious tones (here, this worst spurious level is indicated at a frequency 46). SFDR can be defined with respect to full-scale signal amplitude (dBFS) or carrier level (dBc). Referring to FIG. 1, in radio receiver system 100, the Spurious-Free Dynamic Range (SFDR) of individual ADCs 103 is improved by virtue of spreading power of certain spurious tones over a particular bandwidth, e.g., over the Nyquist bandwidth. This in effect lowers the worst spurious level by at least 10 dB, and sometimes by at least 20 dB, *e.g.,* by about 20-30 dB. For example, the SFDR of individual ADCs 103 may improve from about 30 dB to about 45 dB, or from about 40 dB to about 60 dB, or from about 50 dB to about 75 dB, or from about 60 dB to about 90 dB. In some cases, individual ADCs 103 may have a characteristic noise floor, which is modified and/or raised by virtue of adding the noise signal as described in this disclosure.

In some implementations, SFDR is defined as the ratio of the root mean square (RMS) signal amplitude to the RMS value of the peak spurious spectral content measured over the bandwidth of interest. For example, this bandwidth of interest may be the Nyquist bandwidth.

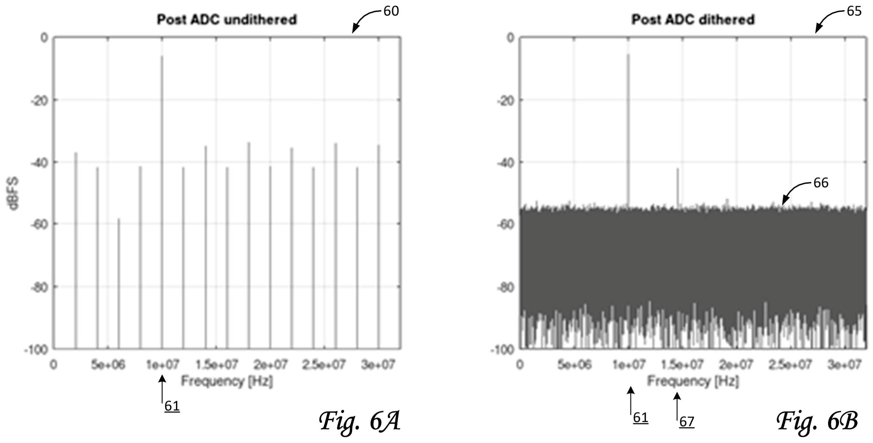

By way of non-limiting example, FIG. 6A depicts a diagram 60 illustrating SFDR of an ADC without an added noise signal, where a frequency 61 indicates an input signal (this is a strong signal at 10 MHz with an RMS of about -6 dBFS, which is relatively close to the full scale amplitude), and the spurious tones (mostly around -40 dBFS) are due to quantization noise, resulting in an SFDR of about 29 dB. A small and/or weak input signal at around 15 MHz, with an RMS of about -40 dBFS is insufficient to cause a presence in the output signals. By way of non-limiting example, FIG. 6B depicts a diagram 65 illustrating SFDR of an ADC using an added noise signal (here, with an RMS of about -9 dBFS). Diagram 65 includes a noise floor 66 at about -55 dBFS, clearly below a spurious tone at a frequency 67 (the small and/or weak input signal at around 15 MHz, with an RMS of about -40 dBFS), resulting in an increased SFDR compared to diagram 60 in FIG. 6A. The increased SFDR in diagram 65 in FIG. 6B is about 45 dB (compared to 29 dB without noise).

In some implementations, the amplitude level on the generated noise signal is significantly higher than the amplitude of the quantization noise (e.g., a difference of 31 dB in FIG. 6B). If the RMS of the noise signal is too weak, the SFDR may not increase as described in this disclosure, or not increase as much as possible. In some implementations, the RMS of the noise signal is based on the RMS of the minimum detectable signal included in the analog input signal. For example, in some cases, the RMS of the noise signal is about 20 dB higher, about 30 dB higher, about 40 dB higher, or between 20-40 dB higher than the RMS of the minimum detectable signal included in the analog input signal.

In some implementations, radio receiver system 100 may be configured to communicate with one or more computing platforms 104 according to a client/server architecture and/or other architectures. In some implementations, the communication uses a peer-to-peer architecture and/or other architectures. Users may access radio receiver system 100 via computing platform(s) 104. In some implementations, radio receiver system 100 and/or components thereof may be configured to communicate with one or more of users 123, and/or other entities and/or components, e.g., through one or more networks 13.

Computing platform(s) 104 may include electronic storage, (hardware) processor(s), machine-readable instructions, and/or other components. Computing platform(s) 104 may be configured by machine-readable instructions. Machine-readable instructions may include one or more instruction components. Instruction components (for any set of machine-readable instructions) may include computer program components. The instruction components may be configured to receive digital outputs 103b from radio receiver system 100. The instruction components may be configured to process and analyze digital outputs 103b (or information derived therefrom), e.g., to extract and/or interpret conveyed information. In some implementations, the instruction components may be configured to generate random information, *e.g.* as input for DAC 56 (depicted in FIG. 5B).

Referring to FIG. 1, in some implementations, aircraft 15 may support autonomous flight control. Alternatively, and/or simultaneously, in some cases, aircraft 15 may support pilot assistance, in particular non-autonomous pilot assistance or, in other words, assisted flight control. Aircraft 15 may include one or more video cameras 15a and a set of sensors 15b such as, *e.g.,* an altimeter, an airspeed sensor, a compass, *etc.* Aircraft 15 may receive and/or generate information regarding presence of other aircraft (e.g., during active flight), Automatic Dependent Surveillance - Broadcast (ads-b) information (In and/or Out), radar and/or flight alarm (FLARM) information, Traffic Alert and Collision Avoidance System (TCAS) information, lowest selectable speed (VLS) information, instrument read-out information (e.g., altimeter, airspeed, compass, *etc.),* timing information, and/or other aircraft-specific information related to aircraft 15.

In some implementations, aircraft 15 may be configured to present interfaces *(e.g.,* user interfaces 125) to users, e.g., through computing platforms 104 associated with the respective users. Presentations of user interfaces to users may include determined geographical information regarding aircraft (and/or information derived therefrom). In some cases, aircraft 15 may recommend an action based on a determination, e.g., to evade a particular detected target 16.

Referring to FIG. 1, user interfaces 125 may be configured to facilitate interaction between users 123, radio receiver system 100, and aircraft 15, and/or between users 123 and computing platforms 104. For example, user interfaces 125 may provide an interface through which users 123 may provide information to and/or receive information from radio receiver system 100 and/or aircraft 15. In some implementations, user interface 125 may include one or more of a display screen, touchscreen, monitor, a keyboard, buttons, switches, knobs, levers, mouse, microphones, sensors to capture voice commands, sensors to capture body movement, sensors to capture hand and/or finger gestures, and/or other user interface devices configured to receive and/or convey user input. In some implementations, one or more user interfaces 125 may be included in one or more computing platforms 104. In some implementations, one or more user interfaces 125 may be included in or operating jointly with radio receiver system 100. In some implementations, user interface 125 may be a type of interface that facilitates the presentation of information regarding events of interest.

Referring to FIG. 1, in some implementations, radio receiver system 100, transmitter 11, aircraft 15, computing platform(s) 104, and/or external resources 138 may be operatively linked via one or more electronic communication links. For example, such electronic communication links may be established, at least in part, via one or more networks 13 such as the Internet and/or other networks. It will be appreciated that this is not intended to be limiting, and that the scope of this disclosure includes operative linking via some other communication media.

A given computing platform 104 may include one or more processors configured to execute computer program components. The computer program components may be configured to enable an expert or user associated with the given computing platform 104 to interface with radio receiver system 100 and/or external resources 138, and/or provide other functionality attributed herein to computing platform(s) 104. By way of non-limiting example, the given computing platform 104 may include one or more of a desktop computer, a laptop computer, a handheld computer, a tablet computing platform, a NetBook, a Smartphone, a gaming console, and/or other computing platforms.

External resources 138 may include sources of information outside of radio receiver system 100, external entities participating with radio receiver system 100, external providers of computation and/or storage services *(e.g.,* a server external to radio receiver system 100), external providers of relevant information *(e.g.,* flight scheduling information, weather information, *etc.),* and/or other resources. In some implementations, some or all of the functionality attributed herein to external resources 138 may be provided by resources included in radio receiver system 100. In some implementations, one or more external resources 138 may provide information to other components of radio receiver system 100.

The electronic storage may comprise non-transitory storage media that electronically stores information. The electronic storage media may include one or both of system storage that is provided integrally *(i.e.,* substantially non-removable) with a corresponding server and/or removable storage that is removably connectable to the corresponding server via, for example, a port *(e.g.,* a USB port, a firewire port, etc.) or a drive *(e.g.,* a disk drive, *etc.).* The electronic storage may include one or more of optically readable storage media *(e.g.,* optical disks, etc.), magnetically readable storage media *(e.g.,* magnetic tape, magnetic hard drive, floppy drive, etc.), electrical charge-based storage media (e.g., EEPROM, RAM, *etc.),* solid-state storage media *(e.g.,* flash drive, *etc.),* and/or other electronically readable storage media. The electronic storage may include one or more virtual storage resources *(e.g.,* cloud storage, a virtual private network, and/or other virtual storage resources). The electronic storage may store software algorithms, information determined by corresponding processor(s), information received from corresponding server(s), information received from computing platform(s) 104, and/or other information that enables radio receiver system 100 to function as described herein.

The processor(s) may be configured to provide information processing capabilities in server(s) 102. As such, the processor(s) may include one or more of a digital processor, an analog processor, a digital circuit designed to process information, an analog circuit designed to process information, a state machine, and/or other mechanisms for electronically processing information. Although the processor(s) could be a single entity, this is not a limiting example. In some implementations, processor(s) may include a plurality of processing units. These processing units may be physically located within the same device, or processor(s) may represent processing functionality of a plurality of devices operating in coordination. Processor(s) may be configured to execute the instruction components by software; hardware; firmware; some combination of software, hardware, and/or firmware; and/or other mechanisms for configuring processing capabilities on the processor(s). As used herein, the term "component" may refer to any component or set of components that perform the functionality attributed to the component. This may include one or more physical processors during execution of processor readable instructions, the processor readable instructions, circuitry, hardware, storage media, or any other components.

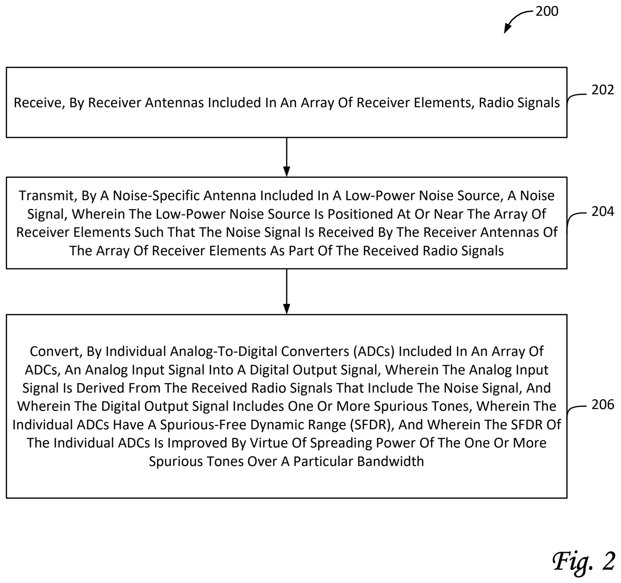

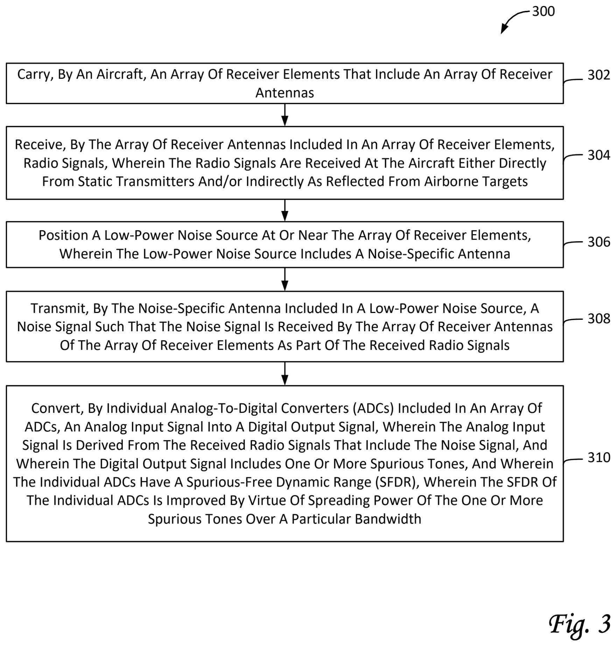

FIG. 2 and FIG. 3 illustrate a method 200 and a method 300 of improving dynamic range of analog-to-digital converters (ADCs) for use with antennas, in accordance with one or more implementations. The operations of method 200 and method 300 presented below are intended to be illustrative. In some implementations, method 200 and/or method 300 may be accomplished with one or more additional operations not described, and/or without one or more of the operations discussed. Additionally, the order in which the operations of method 200 are illustrated in FIG. 2 and described below is not intended to be limiting. The order in which the operations of method 300 are illustrated in FIG. 3 and described below is not intended to be limiting.

In some implementations, method 200 and/or method 300 may be implemented in one or more processing devices (e.g., a digital processor, an analog processor, a digital circuit designed to process information, an analog circuit designed to process information, a state machine, and/or other mechanisms for electronically processing information). The one or more processing devices may include one or more devices executing some or all of the operations of method 200 and/or method 300 in response to instructions stored electronically on an electronic storage medium. The one or more processing devices may include one or more devices configured through hardware, firmware, and/or software to be specifically designed for execution of one or more of the operations of method 200 and/or method 300.

Regarding method 200, at an operation 202, radio signals are received, by receiver antennas included in an array of receiver elements. In some embodiments, operation 202 is performed by receiver antennas the same as or similar to receiver antennas 12 (shown in FIG. 1 and described herein).

At an operation 204, a noise signal is transmitted, by a noise-specific antenna included in a low-power noise source, a noise signal. The low-power noise source is positioned at or near the array of receiver elements such that the noise signal is received by the receiver antennas of the array of receiver elements as part of the received radio signals. In some embodiments, operation 204 is performed by a noise-specific antenna the same as or similar to noise-specific antenna 110 (shown in FIG. 1 and described herein).

At an operation 206, an analog input signal is converted into a digital output signal, by individual analog-to-digital converters (ADCs) included in an array of analog-to-digital converters (ADCs). The analog input signal may be band-limited within a particular bandwidth, such as the Nyquist bandwidth. The analog input signal is derived from the received radio signals that include the noise signal. The digital output signal includes one or more spurious tones. The individual analog-to-digital converters (ADCs) have a Spurious-Free Dynamic Range (SFDR) defined as a strength ratio of a minimum detectable signal level included in the analog input signal and a maximum level of the one or more spurious tones. The Spurious-Free Dynamic Range (SFDR) of the individual analog-to-digital converters (ADCs) is improved by virtue of spreading power of the one or more spurious tones over a particular bandwidth. In some embodiments, operation 206 is performed by analog-to-digital converters (ADCs) the same as or similar to ADCs 103 (shown in FIG. 1 and described herein).

Regarding method 300, at an operation 302, an array of receiver elements that include an array of receiver antennas is carried by an aircraft. In some embodiments, operation 302 is performed by an aircraft the same as or similar to aircraft 15 (shown in FIG. 1 and described herein).

At an operation 304, radio signals are received, by the array of receiver antennas included in an array of receiver elements. The radio signals are received at the aircraft either directly from static transmitters and/or indirectly as reflected from airborne targets. In some embodiments, operation 304 is performed by receiver antennas the same as or similar to receiver antennas 12 (shown in FIG. 1 and described herein).

At an operation 306, a low-power noise source is positioned at or near the array of receiver elements. The low-power noise source includes a noise-specific antenna. In some embodiments, operation 306 is performed by a low-power noise source the same as or similar to low-power noise source 105, or by another component of system 100 (shown in FIG. 1 and described herein).

At an operation 308, a noise signal is transmitted, by the noise-specific antenna included in a low-power noise source, such that the noise signal is received by the array of receiver antennas of the array of receiver elements as part of the received radio signals. In some embodiments, operation 308 is performed by a noise-specific antenna the same as or similar to noise-specific antenna 110 (shown in FIG. 1 and described herein).

At an operation 310, an analog input signal is converted into a digital output signal, by individual analog-to-digital converters (ADCs) included in an array of analog-to-digital converters (ADCs). The analog input signal may be band-limited within a particular bandwidth, such as the Nyquist bandwidth. The analog input signal is derived from the received radio signals that include the noise signal. The digital output signal includes one or more spurious tones. The individual analog-to-digital converters (ADCs) have a Spurious-Free Dynamic Range (SFDR). The Spurious-Free Dynamic Range (SFDR) of the individual analog-to-digital converters (ADCs) is improved by virtue of spreading power of the one or more spurious tones over a particular bandwidth. In some embodiments, operation 310 is performed by analog-to-digital converters (ADCs) the same as or similar to ADCs 103 (shown in FIG. 1 and described herein).

Although the present technology has been described in detail for the purpose of illustration based on what is currently considered to be the most practical and preferred implementations, it is to be understood that such detail is solely for that purpose and that the technology is not limited to the disclosed implementations, but, on the contrary, is intended to cover modifications and equivalent arrangements that are within the spirit and scope of the appended claims. It is to be understood that the present technology contemplates that, to the extent possible, one or more features of any implementation can be combined with features of any other implementation.

## Claims

1. A radio receiver system configured for improving dynamic range of analog-to-digital converters (ADCs) for use with antennas, the system comprising:
an array of receiver elements including receiver antennas, wherein the receiver antennas are configured to receive radio signals;
a low-power noise source including a noise-specific antenna, wherein the low-power noise source is configured to transmit a noise signal, wherein the low-power noise source is positioned at or near the array of receiver elements such that the noise signal is received by the receiver antennas of the array of receiver elements as part of the received radio signals;
an array of analog-to-digital converters (ADCs), wherein individual analog-to-digital converters (ADCs) are configured to convert an analog input signal into a digital output signal, wherein the analog input signal is band-limited within a particular bandwidth, wherein the analog input signal is derived from the received radio signals that include the noise signal, and wherein the digital output signal includes one or more spurious tones, and wherein the individual analog-to-digital converters (ADCs) have a Spurious-Free Dynamic Range (SFDR) defined as a strength ratio of a minimum detectable signal level included in the analog input signal and a maximum level of the one or more spurious tones,
wherein the Spurious-Free Dynamic Range (SFDR) of the individual analog-to-digital converters (ADCs) is improved by virtue of spreading power of the one or more spurious tones over the particular bandwidth.

2. The radio receiver system of claim 1, wherein the noise signal transmitted by the low-power noise source includes frequencies in an operating band of the radio receiver system.

3. The radio receiver system of claim 1, wherein frequencies of the noise signal transmitted by the low-power noise source are band-limited, and wherein the particular bandwidth is the Nyquist bandwidth for complex systems.

4. The radio receiver system of claim 1, wherein frequencies of the noise signal transmitted by the low-power noise source are band-limited to an otherwise unused frequency band.

5. The radio receiver system of claim 1, wherein the SFDR is defined with respect to full-scale signal amplitude (dBFS).

6. The radio receiver system of claim 1, wherein the SFDR of the one or more analog-to-digital converters is improved by at least 10 dB.

7. The radio receiver system of claim 1, wherein the low-power noise source further includes a digital-to-analog converter (DAC), a bandpass filter, a mixer configured to upconvert an input signal using a local oscillator (LO) into a radio-frequency range, and an amplifier configured to connect to the noise-specific antenna.

8. The radio receiver system of claim 1, wherein the array of receiver elements includes at least four receiver antennas.

9. The radio receiver system of claim 1, wherein individual receiver elements further include a low noise amplifier, an IQ mixer, and two low-pass filters.

10. The radio receiver system of claim 1, wherein the radio receiver system is carried by an aircraft, and wherein the radio signals are received at the aircraft either directly from static transmitters and/or indirectly as reflected from airborne targets.

11. A method of improving dynamic range of analog-to-digital converters (ADCs) for use with antennas, the method comprising:
receiving, by receiver antennas included in an array of receiver elements, radio signals;
transmitting, by a noise-specific antenna included in a low-power noise source, a noise signal, wherein the low-power noise source is positioned at or near the array of receiver elements such that the noise signal is received by the receiver antennas of the array of receiver elements as part of the received radio signals;
converting, by individual analog-to-digital converters (ADCs) included in an array of analog-to-digital converters (ADCs), an analog input signal into a digital output signal, wherein the analog input signal is band-limited within a particular bandwidth, wherein the analog input signal is derived from the received radio signals that include the noise signal, and wherein the digital output signal includes one or more spurious tones, and wherein the individual analog-to-digital converters (ADCs) have a Spurious-Free Dynamic Range (SFDR) defined as a strength ratio of a minimum detectable signal level included in the analog input signal and a maximum level of the one or more spurious tones,
wherein the Spurious-Free Dynamic Range (SFDR) of the individual analog-to-digital converters (ADCs) is improved by virtue of spreading power of the one or more spurious tones over the particular bandwidth.

12. The method of claim 11, wherein the noise signal transmitted by the low-power noise source includes frequencies in an operating band of the radio receiver system.

13. The method of claim 11, wherein frequencies of the noise signal transmitted by the low-power noise source are band-limited, and wherein the particular bandwidth is the Nyquist bandwidth for complex systems.

14. The method of claim 13, wherein frequencies of the noise signal transmitted by the low-power noise source are band-limited to an otherwise unused frequency band.

15. The method of claim 11, wherein the SFDR is defined with respect to full-scale signal amplitude (dBFS).

16. The method of claim 11, wherein the array of receiver elements includes at least eight receiver elements, wherein the individual analog-to-digital converters (ADCs) includes at least sixteen ADCs, and wherein the SFDR of the at least sixteen ADCs is improved by virtue of spreading the power of the one or more spurious tones over the particular bandwidth.

17. The method of claim 11, wherein the low-power noise source further includes a digital-to-analog converter (DAC), a bandpass filter, a mixer that upconverts an input signal using a local oscillator (LO) into a radio-frequency range, and an amplifier that connects to the noise-specific antenna.

18. The method of claim 11, wherein the one or more spurious tones are due to quantization errors of the individual analog-to-digital converters (ADCs).

19. The method of claim 11, wherein the radio receiver system is carried by an aircraft, and wherein the radio signals are received at the aircraft either directly from static transmitters and/or indirectly as reflected from airborne targets.

20. A method of improving dynamic range of analog-to-digital converters (ADCs) for use with antennas on an aircraft, the method comprising:
carrying, by the aircraft, an array of receiver elements that include an array of receiver antennas, wherein the array of receiver elements includes at least four receiver elements, and wherein the array of receiver antennas includes at least four receiver antennas;
receiving, by the array of receiver antennas included in an array of receiver elements, radio signals, wherein the radio signals are received at the aircraft either directly from static transmitters and/or indirectly as reflected from airborne targets;
positioning a low-power noise source at or near the array of receiver elements, wherein the low-power noise source includes a noise-specific antenna;
transmitting, by the noise-specific antenna included in a low-power noise source, a noise signal such that the noise signal is received by the array of receiver antennas of the array of receiver elements as part of the received radio signals;
converting, by individual analog-to-digital converters (ADCs) included in an array of analog-to-digital converters (ADCs), an analog input signal into a digital output signal, wherein the analog input signal is derived from the received radio signals that include the noise signal, and wherein the digital output signal includes one or more spurious tones, and wherein the individual analog-to-digital converters (ADCs) have a Spurious-Free Dynamic Range (SFDR),
wherein the Spurious-Free Dynamic Range (SFDR) of the individual analog-to-digital converters (ADCs) is improved by virtue of spreading power of the one or more spurious tones over a particular bandwidth.
